Europäisches Patentamt

European Patent Office

Office européen des brevets

(19)

(11) Veröffentlichungsnummer: **0 311 650**
**B1**

(12) EUROPÄISCHE PATENTSCHRIFT

(45) Veröffentlichungstag der Patentschrift: 16.01.91

(51) Int. Cl.⁵: **H 01 L 39/24**

(21) Anmeldenummer: 88902384.2

(22) Anmeldetag: 31.03.88

(86) Internationale Anmeldenummer:
PCT/CH88/00071

(87) Internationale Veröffentlichungsnummer:
WO 88/08208 20.10.88 Gazette 88/23

(54) **VERFAHREN ZUM HERSTELLEN EINES SUPRALEITERS.**

(30) Priorität: 11.04.87 DE 3712320

(43) Veröffentlichungstag der Anmeldung:
19.04.89 Patentblatt 89/16

(45) Bekanntmachung des Hinweises auf die
Patenterteilung:
16.01.91 Patentblatt 91/03

(84) Benannte Vertragsstaaten:
AT BE CH DE FR GB IT LI LU NL SE

(56) Entgegenhaltungen:
EP-A-0 119 553
DE-A-2 525 980
DE-A-3 245 903

(73) Patentinhaber: ALUSUISSE-LONZA SERVICES
AG
Feldeggstrasse 4
CH-8034 Zürich (CH)

(72) Erfinder: MIER, Gerhard
Birkenweg 9
D-7700 Singen/Hohentwiel (DE)

Courier Press, Leamington Spa, England.

**Beschreibung**

Die Erfindung betrifft ein Verfahren zum Herstellen eines Supraleiters aus einem Niob-Titan- oder Niob-Zinn- Faden als Leiterseele und einer diese umgebenden Ummantelung als Stabilisator, die aus einem Aluminiumbolzen, der vorzugsweise aus hochreinem Aluminium besteht, durch den Formgebungsquerschnitt einer Matrize stranggepreßt wird.

Mit Supraleitfähigkeit wird der physikalische Effekt bezeichnet, daß der elektrische Widerstand bestimmter Metalle bei Temperaturen nahe dem absoluten Nullpunkt (−273°C) zu Null werden kann.

Supraleiter werden in der Meßtechnik, z.B. zur Messung schwacher Magnetfelder und Ströme sowie in der Computertechnik für superschnelle Speicher und Logikbausteine verwendet. Bedeutender sind die Anwendungsgebiete zur Erzeugung starker Magnetfelder z.B. für Großmagnete für Kernkraftwerke, Magnetschwebebahnen, Teilchenbeschleuniger, ferner für supraleitende Spulen, supraleitende Kabel für verlustlose Energieübertragung, supraleitende Generatoren für die Energieerzeugung oder supraleitende Transformatoren und Energiespeicher.

Als Supraleiter dienen dünne Fäden (30 bis 50 µm φ) aus Niob-Titan oder Niob-Zinn, die überlicherweise in einem Kupferdraht eingebettet sind. Dieser Draht wird je nach Verwendungszweck einzeln oder zu einem Bündel verseilt mit hochreinem Aluminium ummantelt, das als Stabilisator dient.

Störungen im Magnetfeld können die Supraleitfähigkeit kurzzeitig unterbrechen. Dann muß der Stabilisator aus hochreinem Aluminium (Reinheit 9,99 bis 99,999%) den Strom kurzzeitig übernehmen. Aluminium eignet sich hierfür besser als Kupfer, weil es bei 4,2 K nur etwa 10% des elektrischen Widerstandes von Kupfer aufweist.

Im Laufe der Jahre kamen immer stärkere Magnetfelder, z.B. für die Teilchenbeschleunigung in der Kernforschung, zum Einsatz. Die Oberwellen, d.h. die zeitlichen Veränderungen, dieser Magnetfelder rufen Wirbelströme in dem Stabilisator aus hochreinem Aluminium hervor, die in unerwünschter Weise Wärme erzeugen und die Supraleitfähigkeit der Niob-Titan- bzw. Niob-Zinnfäden unterbrechen. Während man bisher bei kleineren Magnetfeldern die Wärmeerzeugung der Wirbelströme durch verstärke Heliumkühlung kompensieren konnte, ist dies bei sehr starken Magnetfeldern nicht mehr möglich.

Ein Verfahren der eingangs genannten Art ist aus der DE—A—32 45 903 bekannt. Dort ist eine Leiterseele aus Niob-Titan oder Nb₃Sn vorhanden, die in einem Primärstabilisator aus hochreinem Kupfer oder hochreinem Aluminium eingebettet ist. Der Primärstabilisator ist direkt von einem Sekundärstabilisator umgeben, der aus Reinst-Aluminium besteht. Im stranggepreßten Profilkörper des Sekundärstabilisators sind beidseits der Leiterseele Kühlkanäle vorgesehen, durch die während des Betriebes flüssiges oder siedendes Helium unter Druck geschickt wird.

Es besteht daher die Aufgabe, ein Verfahren der eingangs genannten Art zum Herstellen eines Supraleiters so zu verbessern, daß auch im Bereich sehr starker Magnetfelder die im Aluminium-Stabilisator auftretenden Wirbelströme so klein gehalten werden, daß die von den Wirbelströmen erzeugte Wärme gegebenenfalls von der Heliumkühlung schnell genug abgeführt werden kann, auf jeden Fall aber so gering ist, daß die Supraleitfähigkeit nicht beeinträchtigt wird.

Die Erfindung geht bei der Lösung dieser Aufgabe von der Erkenntnis aus, daß es erforderlich ist, die in der als Stabilisator eingesetzten Aluminium-Ummantelung auftretende Wirbelströme zu reduzieren.

Zur Lösung dieser Aufgabe führt, daß ein Aluminiumbolzen mit koaxial zu seiner Längsachse verlaufenden, aus einem schlecht leitenden festen Werkstoff bestehenden Strukturen in Form von über den Bolzenquerschnitt verteilten Schichten, bandförmigen Streifen oder in engen Abständen längsverlaufenden Einzelfäden oder -fasern oder Faserbündeln eingesetzt und mit der Leiterseele zu einem Supraleiter verpreßt wird, der eine stark verringerte elektrische Leitfähigkeit quer zur Leiterlängsachse durch die in die Aluminium-Ummantelung eingebetten koaxial verlaufenden, aus dem schlecht leitenden festen Werkstoff bestehende Strukturen aufweist.

Dabei ist an sich aus der DE—A—25 25 980 ein stabilisierter Supraleiter bakannt, bei dem zum Erzielung einer metallisch innigen Verbindung zwischen den einzelnen Bolzenbestandteilen mit Hilfe einer Warmbehandlung die supraleitenden Fäden durch Hineindiffundieren von einer in der Matrix enthaltenen diffusionsfähigen Materialkomponente in eine im Innern des Leiters fadenförmig angeordnete Materialkomponente gebildet werden.

Dieser bekannte Supraleiter ist schichtweise im Querschnitt von innen nach außen aus zum Teil gut leitfähigem, zum Teil hochohmigem Werkstoff aufgebaut. Die Leiterseele besteht aus vielen Niobstäben, die zur Verringerung der Wirbelstromverluste einzeln von einer hochohmigen Schicht umgeben sind. Diese ummantelten Niobstäbe sind von Bronzerohren umgeben oder in einem Bronzeblock eingebettet. Darauf folgt als Mantel eine Schicht aus Kupferstäben und darauf eine Hülse aus einer hochohmigen Legierung und einer Diffusionssperre, die die Kupferstäbe als Mantel umgibt.

Als äußerste Schicht ist ein Hohlzylinder aus schlecht leitendem Material vorgesehen, der evtl. auch aus Messing sein kann. Die gesamte Anordnung dieses bekannten Supraleiters mag zwar Wirbelströme durch Anordnung eines schlecht leitenden Werkstoffes dämpfen, ist aber nur mit sehr hohen Kosten und keineswegs im Strangpreßverfahren herstellbar.

In der DE—A—25 25 980 ist außerdem noch ein gesonderter Stand der Technik kurz erwähnt, wonach die Supraleiterseelen von einer Bronzematrix umgeben sind, die ihrerseits von einer Diffusionssperre und die letztere von elektrisch gut leitendem Kupfer oder Aluminium umgeben ist, wobei eine solche Anordnung als ungeeignet bezeichnet wird.

Besondere Weiterbildungen der Erfindung sind in den Unteransprüchen gekennzeichnet.

Die in die Aluminium-Ummantelung eingebetteten koaxial verlaufenden Schichten aus dem schlecht leitenden Werkstoff können als geschlossene, die Leiterseele in einem Abstand umgebende und einen Abstand voneinander aufweisende konzentrische Ringmantelschichten ausgebildet sein, wobei zusätzlich oder alternativ die bandförmigen Streifen aus dem schlecht leitenden Werkstoff in einer zur Leiterseele sternförmigen Konfiguration angeordnet sein können.

Eine abgewandelte Ausbildung des Stabilisators nach der Erfindung ist auch darin zu sehen, daß die längsverlaufenden, in enger Querschnittsverteilung in die Aluminium-Ummantelung eingebetteten Einzelfäden oder -fasern oder Faserbündel aus Glasfasern oder Oxidfasern bestehen.

Dabei können nach einem weiteren Merkmal die Streifen, Einzelfäden oder -fasern oder Faserbündel aus dem schlecht leitenden Werkstoff in koaxial verlaufender Richtung einen geringen Querschnitt, jedoch in den quer zur Längserstreckung verlaufenden Richtungen eine wesentlich größere Flächenprojektion aufweisen.

Der prinzipielle Vorteil des durch das erfindungsgemäße Verfahren stranggepreßten Supraleiters gegenüber dem Stand der Technik ist die Anisotropie der elektrischen Leitfähigkeit des Aluminium-Stabilisators, d.h. die unterschiedliche Leitfähigkeit längs bzw. quer zur Preßrichtung. Dadurch wird die Aufgabe der Erfindung erfüllt, den elektrischen Strom in Längsrichtung ungehindert passieren zu lassen, wogegen die Wirbelströme quer zur Preßrichtung durch eine herabgesetzte Leitfähigkeit stark reduziert werden.

Die Ummantelung der Leiterseele erfolgt im Strangpreßverfahren, bei dem ein im Rezipienten der Strangpresse aufgenommener Voll- oder Hohlbolzen aus Reinst-Aluminium durch eine Matrize ausgepreßt wird und der Aluminiumbolzen mit koaxial zu seiner Längsachse verlaufenden, aus einem schlecht leitenden Werkstoff bestehenden Strukturen in Form von über den Bolzenquerschnitt verteilten Schichten, bandförmigen Streifen oder in engen Abständen längsverlaufenden Einzelfäden oder -fasern oder Faserbündeln versehen ist.

Dabei kann in Weiterbildung ein Voll- oder Hohlbolzen von kreisrundem, ovalem oder polygonalem Querschnitt, ausgehend von einem kreis-, oval- oder polygonalzylindrischen vollen oder hohlen Kernteil, durch abwechselnd aufeinanderfolgendes Aufsprühen von dicken Schichten aus Reinst-Aluminium und dünnen Schichten aus schlecht leitendem Werkstoff hergestellt sein. Das Aufsprühen kann vorzugsweise bei rotierendem Bolzen erfolgen.

In Abwandlung hiervon kann ein kreisrunder, ovaler oder polygonaler Voll- oder Hohlbolzen aus Reinst-Aluminium im Gießverfahren hergestellt werden; und in die Gießform oder die Schmelze können Glasfasern, Oxidfasern oder Stränge bzw. Fasern aus einem anderen hochohmigen Material eingebracht werden, die sich beim Auspressen des Bolzens unter Verringerung ihres Querschnitts in die Länge ziehen.

Ferner wird in weiterer Ausbildung des Verfahrens vorgeschlagen, daß zur Herstellung von Trennfugen im fertiggepreßten Ummantelungsstrang aus dem Reinst-Aluminium die Matrize der Strangpresse mit feststehenden Stegen versehen ist, durch welche eine Teilung des Bolzenmaterials in Einzelstränge herbeigeführt wird, die beim Austreten aus der Matrize wieder zu einem, die Fugen aufweisenden Gesamtstrang zusammengeführt werden. In den Fugen kann dann ein schlecht leitender Werkstoff angeordnet sein.

Eine besonders vorteilhafte Lösung der gestellten Aufgabe besteht darin, daß—wie eingangs erwähnt—bandförmige Streifen aus schlecht leitendem Werkstoff in die Aluminium-Umhantelung eingebettet werden. Hierzu wird das Verfahren dahingehend vorgeschlagen, daß einerseits die Ummantelung der Leiterseele in Strangpreßverfahren erfolgt, wobei ein im Rezipienten der Strangpresse aufgenommener Voll- oder Hohlbolzen aus homogenem Reinst-Aluminium durch eine Matrize ausgepreßt wird, in welche durch entsprechend bemessene Kanäle bandförmige Streifen, Faserbündel oder dgl. langgestreckte Gebilde aus einem schlecht leitenden Werkstoff in die sich bildende Ummantelung aus dem Reinst-Aluminium eingeleitet werden. Dabei werden die durch die Matrize während des Auspressens in die Ummantelung eingeleiteten bandförmigen Streifen in sternförmig zur Leiterseele hin ausgerichteter Konfiguration eingebettet. Nach einem abgewandelten Verfahren kann die Ummantelung auch im Strangpreß-Verbundverfahren hergestellt sein, bei dem zunächst in einem ersten Preßvorgang die Leiterseele mit einer ersten Mantelschicht umpreßt und auf diese Mantelschicht eine dünne Schicht aus einem schlecht leitenden Werkstoff aufgebracht und darauf durch Auspressen durch eine Folgematrize eine zweite Mantelschicht aus Reinst-Aluminium darüber aufgepreßt wird. Selbstverständlich kann auch auf die zweite und jede weitere folgende Mantelschicht aus Reinst-Aluminium jeweils eine weitere dünne Schicht aus dem schlecht leitenden Werkstoff aufgebracht werden. Jedoch ist vorgesehen, daß auf die äußerste Mantelschicht aus Reinst-Aluminium keine weitere dünne Schicht aus dem schlecht leitenden Werkstoff aufgebracht wird.

Die verschiedenen Verfahrensweisen nach der Erfindung gestatten es, je nach den geforderten physikalisch-technischen Eigenschaften und den Einsatzbedingungen Supraleiter herzustellen, bei denen die Wirbelströme in hohem Maße unterdrück und damit auch die unerwünschte Erwärmung auf ein Mindestmaß beschränkt wird.

Die Erfindung wird nachfolgend anhand von Ausführungsbeispielen näher erläutert. Es zeigen

Fig. 1 einen Strangpreßbolzen mit kreisringförmigen Schichten aus schlecht leitendem Werkstoff,

Fig. 2 einen Strangpreßbolzen mit faserförmigen Strukturen aus schlecht leitendem Werkstoff,

Fig. 3 einen Querschnitt durch eine Faser nach Fig. 2 aus einem schlecht leitendem Werkstoff,

Fig. 4 eine Strangepreßmatrize für einen Rund-Rezipienten mit Stegen,

Fig. 5 eine Strangpreßmatrize für einen Rechteck-Rezipienten mit Stegen,

Fig. 6 einen stranggepreßten Supraleiter von rechteckigem Querschnitt in einer anderen Ausführungsform,

Fig. 7 eine andere Ausführungsform eines stranggepreßten Supraleiters nach Fig. 6.

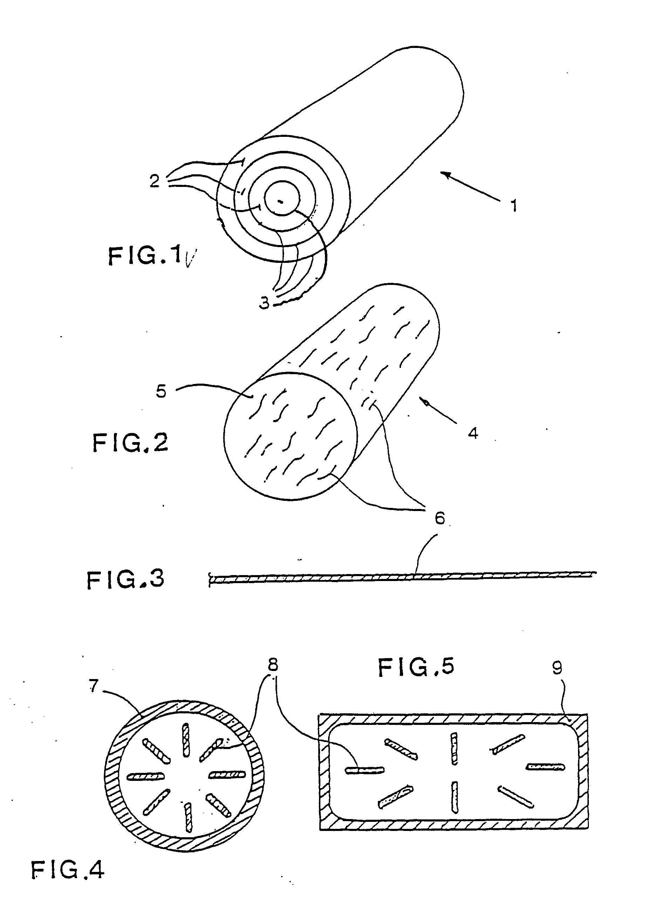

Der in Fig. 1 dargestellte Strangpreß-Vollbolzen 1 von kreisrundem Querschnitt besteht aus Reinst-Aluminium (AL 99,999). Dieser Werkstoff ist jedoch durch dünne ringmantelförmige Schichten 3 aus einem schlecht leitenden Werkstoff in zylinderwalzenförmige Einzelkörper getrennt. Der Strangpreß-Vollbolzen 1 wird durch abwechselnd aufeinanderfolgendes Aufsprühen von dicken Schichten 2 aus Reinst-Aluminium und dünnen Schichten 3 aus dem schlecht leitenden Werkstoff hergestellt.

Der Strangpreß-Vollbolzen 4 nach Fig. 2 ist im Gießverfahren hergestellt und besteht ebenfalls aus Reinst-Aluminium (AL 99,999). Die schlecht leitenden Strukturen sind in Form von Glas- oder Oxidfasern 6 in die Gießform und/oder in die Schmelze eingebracht worden.

In Fig. 3 ist stark vergrößert in Querschnitt durch eine Faser 6 in Preßrichtung dargestellt, wie sie in den gegossenen Strangpreß-Vollbolzen 4 gemäß Fig. 2 eingelagert sind. In Längsrichtung weisen die Fasern 6 aus einem schlecht leitenden Werkstoff vorzugsweise einen runden oder ovalen Querschnitt auf.

Die Fig. 4 zeigt eine Stirnansicht einer Strangpreß-Rundmatrize 7, die mit Stegen 8 ausgeführt ist. Die Stege 8 sind im Ausführungsbeispiel zentrisch nach innen zum Mittelpunkt hin gerichtet und dienen dazu, das Bolzenmaterial beim Strangpressen in acht Einzelstränge aufzuteilen. Nach dem Austreten aus der Matrize verschweißen diese Einzelstränge wieder zu einem geschlossenen Gesamtstrang, der jedoch zwischen den acht Einzelsträngen Schweißnähte aufweist.

In Fig. 5 ist weiterhin die Stirnansicht einer Strangpreß-Rechteckmatarize 9 dargestellt, die ebenfalls Stege 8 aufweist, durch welche das Bolzenmaterial beim Strangpressen in acht Einzelstränge aufgeteilt wird. Nach dem Verschweißen dienen die Schweißnähte der Verschlechterung der Leitfähigkeit. Selbstverständlich ist es möglich, einen Strangpreß-Bolzen 5 nach Fig. 2 mit eingelagerten Fasern 6 in einer Matrize 7 nach Fig. 4 zu verpressen, so daß sich die Maßnahmen zur Verringerung der Leitfähigkeit ergänzen und verstärken.

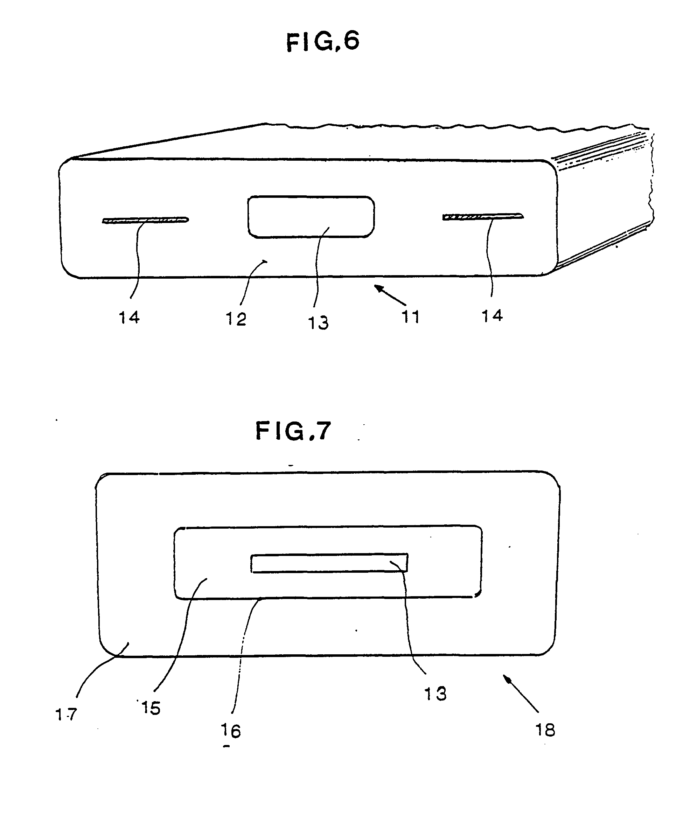

Die Fig. 6 zeigt einen Querschnitt durch einen stabilisierten Supraleiter 11 mit einem Kern 13, der aus einer Niob-Titan- oder Niob-Zinn- Legierung bestehen kann. Der Stabilisator ist als rechteckiger Mantel 12 aus Reinst-Aluminium ausgebildet, in welchen die Bänder 14 aus einem schlecht leitenden Werkstoff eingelagert sind, um die Wirbelströme in dem Aluminium-Stabilisator zu vermindern.

Eine Abwandlung des Supraleiters 18 gemäß Fig. 6 ist in Fig. 7 in Stirnansicht dargestellt. Die aus einer Niob-Titan- oder Niob-Zinn- Legierung bestehende Leiterseele 13 ist von dem Stabilisatormantel 15 aus Reinst-Aluminium umgeben. Dieses Verbund-Rechteckprofil kann in einem ersten Strangpreßvorgang hergestellt sein. Auf diesen Mantel 15 aus Reinst-Aluminium wird nun die Isolierschicht 16 aus dem schlecht leitenden Werkstoff aufgespritzt oder aufgedampft. Darauf wird in einem weiteren Strangpreßvorgang der äußere Mantel 17 ebenfalls aus Reinst-Aluminium—oder aus einer ähnlichen Alu-Legierung—aufgepreßt. Auch hier können in die Ummantelungen 15 und 17 Bänder oder Fasern aus einem schlecht leitenden Werkstoff eingelagert sein.

**Patentansprüche**

1. Verfahren zum Herstellen eines Supraleiters aus einem Niob-Titan- oder Niob-Zinn- Faden als Leiterseele und einer die Leiterseele umgebenden Ummantelung als Stabilisator, wobei die Ummantelung aus einem Aluminiumbolzen, der vorzugsweise aus hochreinem Aluminium besteht, durch den Formgebungsquerschnitt eine Strangpreßmatrize stranggepreßt wird, dadurch gekennzeichnet, daß ein Aluminiumbolzen mit koaxial zu seiner Längsachse verlaufenden, aus einem schlecht leitenden festen Werkstoff bestehenden Strukturen in Form von über den Bolzenquerschnitt verteilten Schichten, bandförmigen Streifen oder in engen Abständen längsverlaufenden Einzelfäden oder -fasern oder Faserbündeln eingesetzt und mit der Leiterseele zu einem Supraleiter verpreßt wird, der eine stark verringerte elektrische Leitfähigkeit quer zur Leiterlängsachse durch die in die Aluminium-Ummantelung eingebetteten koaxial verlaufenden, aus dem schlecht leitenden festen Werkstoff bestehenden Strukturen aufweist.

2. Verfahren nach Anspruch 1, dadurch gekennzeichnet, daß die in die Aluminium-Ummantelung eingebetteten koaxial verlaufenden Schichten aus dem schlecht leitenden Werkstoff als geschlossene, die Leiterseele in einem Abstand umgebende und einen Abstand voneinander aufweisende konzentrische Ringmantelschichten ausgebildet werden.

3. Verfahren nach Anspruch 1 oder 2, dadurch gekennzeichnet, daß ein Voll- oder Hohlbolzen von kreisrundem, ovalem oder polygonalem Querschnitt mit kreisrundem-, ovalem- oder polygonalzylindrischem vollen oder hohlen Kernteil durch abwechselnd aufeinanderfolgendes Aufsprühen von dicken Schichten aus Reinst-Aluminium und dünnen Schichten aus schlecht leitendem Werkstoff hergestellt wird.

4. Verfahren nach Anspruch 3, dadurch gekennzeichnet, daß der Bolzen während des Aufsprühens in Rotation gehalten wird.

5. Verfahren nach einem der Ansprüche 1 oder 2, dadurch gekennzeichnet, daß während des Strangpressens in einem ersten Preßvorgang die Leiterseele von einer ersten Mantelschicht umpreßt, dann eine dünne Schicht aus dem schlecht leitenden Werkstoff aufgebracht und darauf durch Auspressen durch eine Folgematrize eine weitere Mantelschicht aus Reinst-Aluminium darüber aufgepreßt wird.

6. Verfahren nach Anspruch 5, dadurch gekennzeichnet, daß auf die zweite und weitere folgende Mantelschichten aus Reinst-Aluminium jeweils eine weitere dünne Schicht aus dem schlecht leitenden Werkstoff aufgebracht wird.

7. Verfahren nach Anspruch 5 oder 6, dadurch gekennzeichnet, daß als äußerste Mantelschicht Reinst-Aluminium aufgebracht wird.

8. Verfahren nach einem der Ansprüche 1 bis 7, dadurch gekennzeichnet, daß die in die Aluminium-Ummantelung in engen Abständen längsverlaufend eingebetteten Einzelfäden oder -fasern oder Faserbündel aus Glasfasern oder Oxidfasern bestehen.

9. Verfahren nach Anspruch 1 oder 8, dadurch gekennzeichnet, daß in kreisrunder, ovaler oder polygonaler Bolzen aus Reinst-Aluminium im Gießverfahren hergestellt wird und in die Gießform oder die Schmelze Glasfasern, Oxidfasern oder Stränge bzw. Fasern aus einem anderen hochohmigen Material eingebracht werden, die beim Auspressen des Bolzens unter Verringerung ihres Querschnitts in die Länge gezogen werden.

10. Verfahren nach einem der Ansprüche 1 bis 9, dadurch gekennzeichnet, daß die Ummantelung der Leiterseele durch eine Strangpreßmatrize ausgepreßt wird, in welche durch entsprechend bemessene Kanäle bandförmige Streifen, Faserbündel od. dgl. langgestreckte Gibilde aus dem schlecht leitenden Werkstoff in die sich bildende Ummantelung aus dem Reinst-Aluminium eingeleitet werden.

11. Verfahren nach Anspruch 10, dadurch gekennzeichnet, daß die durch die Strangpreßmatrize während des Auspressens in die Ummantelung eingeleiteten bandförmigen Streifen in sternförmig zur Leiterseele hin ausgerichteter Konfiguration eingebettet werden.

12. Verfahren nach einem der Ansprüche 8 bis 11, dadurch gekennzeichnet, daß die Streifen, Einzelfäden oder -fasern oder Faserbündel aus dem schlecht lietenden Werkstoff in koaxial verlaufender Richtung mit einem geringen Querschnitt, jedoch mit in den quer zur Längserstrekkung verlaufenden Richtungen mit einer wesentlich größeren Flächenprojektion eingebracht werden.

13. Verfahren nach einem der Ansprüche 10 bis 12, dadurch gekennzeichnet, daß zum Herstellen von Trennfugen im fertiggepreßten Ummantelungsstrang aus dem Reinst-Aluminium eine Teilung des Bolzenmaterials in Einzelstränge durch eine Strangpreßmatrize mit feststehenden Stegen durchgeführt wird, wobei die Einzelstränge nach dem Austreten aus der Matrize wieder zu einem die Fugen aufweisenden Gesamtstrang zusammengeführt werden.

14. Verfahren nach einem der Ansprüche 10 bis 12, dadurch gekennzeichnet, daß der Bolzen durch eine in der Nähe des Austritts mit festehenden Stegen versehene Strangpreßmatrize unter Teilung des Bolzenwerkstoffes in Einzelstränge ausgepreßt wird, die nach dem Passieren des Stegbereichs und vor dem Austreten aus der Matrize wieder zu einem Trennfugen aufweisenden Gesamtstrang zusammengeführt werden.

**Revendications**

1. Procédé de fabrication d'un supraconducteur constitué par un filament de niobium-titane ou de niobium-étain en tant qu'âme conductrice et par une enveloppe entourant l'âme conductrice en tant que stabilisateur, l'enveloppe étant filée à travers la section de façonnage d'une matrice de filage à partir d'une barre d'aluminium qui consiste de préférence en aluminium très pur, caractérisé en ce qu'une barre d'aluminium, dans laquelle sont incorporées des structures qui s'étendent coaxialement à son axe longitudinal, consistant en un matériau solide mauvais conducteur, sous forme de couches réparties sur la section de la barre, de bandes en forme de rubans ou de filaments ou fibres isolés ou de faisceaux de fibres faiblement distants qui s'étendent longitudinalement, est comprimée avec l'âme conductrice en un supraconducteur qui présente une conductivité électrique fortement diminuée transversalement à l'axe longitudinal du conducteur du fait des structures constituées par le matériau solide mauvais conducteur qui sont noyéesdans l'enveloppe en aluminium et qui s'étendent coaxialement.

2. Procédé selon la revendication 1, caractérisé en ce que les couches en matériau mauvais conducteur qui sont incorporées dans l'enveloppe en aluminium et qui s'étendent coaxialement sont sous forme de couches d'enveloppe annulaire fermées concentriques à distance les unes des autres et qui entourent l'âme conductrice en en étant séparées.

3. Procédé selon la revendication 1 ou 2, caractérisé en ce que l'on fabrique une barre pleine ou creuse de section circulaire, ovale ou polygonale avec une partie formant coeur pleine ou creuse cylindrique circulaire, ovale ou polygonale par aspersion alternée de couches épaisses d'aluminium ultrapur et de couches minces de matériau mauvais conducteur.

4. Procédé selon la revendication 4, caractérisé en ce que la barre est maintenue en rotation au cours de l'aspersion.

5. Procédé selon l'une des revendications 1 ou 2, caractérisé en ce que, pendant le filage, l'âme conductrice est enrobée d'une première couche d'enveloppe dans un premier processus de filage, puis une mince couche du matériau mauvais conducteur est appliquée et une autre couche d'enveloppe en aluminium ultrapur est appliquée par pression sur celle-ci par éjection à travers une matrice supplémentaire.

6. Procédé selon la revendication 5, caractérisé en ce qu'une autre couche mince en le matériau mauvais conducteur est appliquée sur la deuxième couche d'enveloppe et sur les couches d'enveloppe suivantes.

7. Procédé selon la revendication 5 ou 6, caractérisé en ce que l'on applique de l'aluminium ultrapur comme couche d'enveloppe externe.

8. Procédé selon l'une des revendications 1 à 7, caractérisé en ce que les différents filaments ou fibres ou faisceaux de fibres incorporés dans l'enveloppe en aluminium en s'étendant longitudinalement à faible distance les uns des autres consistent en des fibres de verre ou des fibres d'oxyde.

9. Procédé selon la revendication 1 ou 8, caractérisé en ce qu'une barre circulaire, ovale ou polygonale en aluminium ultrapur est fabriquée dans le procédé de coulée et en ce que dans le moule ou la masse fondue sont ajoutées des fibres de verre, des fibres d'oxyde ou des brins ou fibres en un autre matériau à haute résistance qui sont étirés suivant la longueur au cours de l'éjection de la barre avec réduction de leur section.

10. Procédé selon l'une des revendications 1 à 9, caractérisé en ce que l'enveloppe de l'âme conductrice est éjectée à travers une matrice de filage dans laquelle sont introduites par des canaux dimensionnés de façon correspondante des bandes en forme de rubans, des faisceaux de fibres ou des produits allongés analogues en le matériau mauvais conducteur dans l'enveloppe en aluminium ultrapur qui se forme.

11. Procédé selon la revendication 10, caractérisé en ce que les bandes en forme de rubans qui sont introduites dans l'enveloppe par la matrice de filage au cours de l'éjection sont incorporées suivant une configuration étoilée dirigée vers l'âme conductrice.

12. Procédé selon l'une des revendications 8 à 11, caractérisé en ce que les bandes, les filaments ou fibres individuels ou les faisceaux de fibres en le matériau mauvais conducteur sont introduits avec une faible section dans la direction qui s'étend coaxialement mais avec une projection de surface sensiblement plus grande dans les directions qui s'étendent transversalement à l'étendue longitudinale.

13. Procédé selon l'une des revendications 10 à 12, caractérisé en ce que pour produire des fentes de séparation dans la barre d'enveloppe filée et terminée en aluminium ultrapur, on réalise une division du matériau de la barre en barres individuelles dans une matrice de filage comportant des traverses fixes, les barres individuelles étant de nouveau réunies après la sortie de la matrice en une barre totale qui présente les fentes.

14. Procédé selon l'une des revendications 10 à 12, caractérisé en ce que la barre est éjectée à travers une matrice de filage munie de traverses fixes à proximité de la sortie avec division du matériau de la barre en barres individuelles qui sont de nouveaux réunies et une barre totale présentant des fentes de séparation après le passage de la zone des traverses et avant la sortie de la matrice.

## Claims

1. Process for producing a superconductor from a niobium-titanium or nobium-tin filament as conductor core and from a sheath surrounding the conductor core as stabilizer, the sheath being extruded from an aluminium bolt, which preferably consists of high-purity aluminium, by the forming cross-section of an extrusion die, characterized in that an aluminium bolt, which has structures extending coaxially with its longitudinal axis, consisting of a poorly conductive solid material and being distributed over the bolt cross-section in the form of layers, band-shaped strips or individual filaments or fibres, extending longitudinally at close intervals, or of fibre bundles, is used and pressed with the conductor core to form a superconductor which has a strongly reduced electrical conductivity transverse to the longitudinal axis of a conductor owing to the coaxially extending structures which are embedded in the aluminium sheath and consist of the poorly conductive solid material.

2. Process according to Claim 1, characterized in that the coaxially extending layers made of the poorly conductive material, which are embedded in the aluminium sheath, are constructed as closed concentric annular sheathing layers wich surround the conductor core at a distance and are at an interval from one another.

3. Process according to Claim 1 or 2, characterized in that a solid or hollow bolt of circular, oval or polygonal cross-section and having a circularly, ovally or polygonally cylindrical solid or hollow core part is produced by alternating sequential spraying of thick layers of refined aluminium and thin layers of poorly conductive material.

4. Process according to Claim 3, characterized in that during the spraying the bolt is held in rotation.

5. Process according to one of Claims 1 or 2, characterized in that during the extrusion in a first pressing process the conductor core is pressed around by a first sheathing layer, then a thin layer made of the poorly conductive material is applied and thereafter a further sheathing layer made from refined aluminium is pressed thereupon by being pressed out by means of a subsequent die.

6. Process according to Claim 5, characterized in that a further thin layer made of the poorly conductive material is applied in each case to the second and further subsequent sheathing layers made from refined aluminium.

7. Process according to Claim 5 or 6, characterized in that refined aluminium is applied as the outermost sheathing layer.

8. Process according to one of Claims 1 to 7, characterized in that the individual filaments or fibres or fibre bundles, embedded and extending longitudinally at close intervals in the aluminium sheath consist of glass fibres or oxide fibres.

9. Process according to Claim 1 or 8, characterized in that a circular, oval or polygonal bolt is made from refined aluminium using a casting process, and there are introduced into the casting mould or the melt glass fibres, oxide fibres or strands or fibres made of another high-resistance material which are drawn out in length accompanied by a reduction in their cross-section when the bolt is pressed out.

10. Process according to one of Claims 1 to 9, characterized in that the sheath of the conductor core is pressed out by means of an extrusion die in which by means of appropriately dimensioned channels band-shaped strips, fibre bundles or similar elongate configurations made of the poorly conductive material are introduced into the sheath, made from the refined aluminium, which forms.

11. Process according to Claim 10, characterized in that the band-shaped strips introduced by means of the extrusion die during pressing out into the sheath are embedded in a stellate configuration oriented towards the conductor core.

12. Process according to one of Claims 8 to 11, characterized in that the strips, individual filaments or fibres or the fibre bundles made of poorly conductive material are introduced in the coaxially extending direction with a small cross-section, but in the directions extending transverse to the longitudinal extent with a substantially larger developed surface.

13. Process according to one of Claims 10 to 12, characterized in that in order to produce separating joints in the finished pressed sheathing strand made from the refined aluminium a separation of the bolt material into the individual strands is carried out by means of an extrusion die having fixed webs, the individual strands being brought together once again after emerging from the die to form a combined strand having the joints.

14. Process according to one of Claims 10 to 12, characterized in that by means of an extrusion die provided with fixed webs in the vicinity of the emergence of the bolt said bolt is pressed out with separation of the bolt material into individual strands which after passing the web region and before emerging from the die are once again brought together to form a combined strand having separating joints.

FIG.1

2

3

1

FIG.2

5

4

6

FIG.3

FIG.4

7

8

FIG.5

9

1

## FIG.6

14    12    13    11    14

## FIG.7

17    15    16    13    18